# EUROPÄISCHE PATENTSCHRIFT

(11) **EP 0 301 442 B1**
(45) Veröffentlichungstag und Bekanntmachung des Hinweises auf die Patenterteilung: **31.03.1993**
(21) Anmeldenummer: 88111880.6
(22) Anmeldetag: 23.07.1988
(51) Int. Cl.: G01R 31/02

(54) **Schaltungsanordnung zur Überprüfung der Zuleitungen eines Schalters oder Sensors**
Circuit for checking the leads to a switch or a sensor
Circuit pour la supervision de fils vers un interrupteur ou un détecteur

(30) Priorität: 28.07.1987 DE 3724926
(43) Veröffentlichungstag der Anmeldung: 01.02.1989
(73) Patentinhaber: Bayerische Motoren Werke Aktiengesellschaft, 80788 München (DE)
(72) Erfinder: Hillebrand, Helmut, D-8000 München 81 (DE)

(56) Entgegenhaltungen:
- EP-A- 0 032 694
- DE-A- 3 011 230
- US-A- 3 629 816
- US-A- 3 849 759
- US-A- 4 218 677
- US-A- 4 673 912

## Beschreibung

Die Erfindung betrifft eine Schaltungsanordnung zur Überprüfung der Zuleitungen eines im Ruhezustand offenen Schalters oder Sensors nach dem Oberbegriff des Patentanspruchs 1.

Eine derartige Schaltungsanordnung wird bereits zur Überprüfung der Funktionsfähigkeit der Zuleitungen zu einem Sensor eines Airbag-Steuergerätes eines Kraftfahrzeuges eingesetzt. Da bei dieser bekannten Schaltungsanordnung die Ausgangsspannung der Spannungsversorgungseinrichtung kleiner als die Akkumulatorspannung des Kraftfahrzeuges gewählt wurde, kann die an die Spannungsversorgungseinrichtung angeschlossene Zuleitung des Sensors im Hinblick auf einen Kurzschluß gegen Erdpotential, einen Kurzschluß gegen die Akkumulatorspannung sowie eine Leitungsunterbrechung überprüft werden. Ferner kann die mit Erdpotential verbundene Zuleitung des Sensors hinsichtlich eines Kurzschlusses gegen die Akkumulatorspannung sowie einer Leitungsunterbrechung überwacht werden. Diese Überprüfungsmöglichkeiten der Zuleitungen des Sensors sind darauf zurückzuführen, daß sowohl bei den beiden Schaltzuständen des Sensors bei intakten Zuleitungen als auch bei fehlerhaften Zuleitungen entsprechend dem jeweiligen Leitungsfehler jeweils ein definierter Spannungspegel an der Spannungsdiskriminatoreinheit anliegt. So liegt bei intakten Zuleitungen bei offenem Sensor an der Spannungsdiskriminatoreinheit eine Spannung an, die durch den aus dem zweiten und dritten ohmschen Widerstand gebildeten Spannungsteiler bestimmt wird. Ferner liegt bei geschlossenem Sensor an der Spannungsdiskriminatoreinheit eine Spannung an, die durch den aus dem ersten, zweiten und dritten ohmschen Widerstand gebildeten Spannungsteiler bestimmt wird. Von diesen beiden, bei intakten Zuleitungen zum Sensor an der Spannungsdiskriminatoreinheit auftretenden Spannungen unterscheiden sich die Spannungen, die bei den vorstehend genannten Fehlern an der Spannungsdiskriminatoreinheit auftreten. So liegt beispielsweise bei einem Kurzschluß der an die Spannungsversorgungseinrichtung angeschlossenen Zuleitung des Sensors gegen die Akkumulatorspannung die Akkumulatorspannung, bei einem Kurzschluß gegen Erdpotential das Erdpotential und bei einer Leitungsunterbrechung die Ausgangsspannung der Spannungsversorgungseinrichtung an der Spannungsdiskriminatoreinheit an.

Diese bekannte Schaltungsanordnung hat lediglich den Nachteil, daß bei einsatzbereitem Sensor auch in dessen Offenstellung über den zweiten und dritten ohmschen Widerstand stets ein Diagnosestrom fließt. Dies hat die Folge, daß die bekannte Schaltungsanordnung im Kraftfahrzeugbau nur bei solchen Sensoren bzw. Schaltern eingesetzt werden kann, die bei ausgeschaltetem Zündschalter nicht an Spannung liegen, da ansonsten während des Stillstandes des Kraftfahrzeuges der Akkumulator entladen wird, wodurch nach einer längeren Standzeit des Kraftfahrzeuges dieses nicht mehr gestartet werden kann.

Es ist ist daher Aufgabe der Erfindung, eine Schaltungsanordnung eingangs genannter Art so weiterzubilden, daß sie auch zur Überprüfung der Zuleitungen von Schaltern oder Sensoren verwendet werden kann, die auch bei ausgeschaltetem Zündschalter an Spannung liegen.

Diese Aufgabe wird erfindungsgemäß durch die kennzeichnenden Merkmale des Patentanspruchs 1 gelöst.

Da der zweite ohmsche Widerstand zur Funktionsfähigkeit des Schalters oder Sensors nicht erforderlich ist, sondern lediglich benötigt wird, um bei offenem Schalter oder Sensor dessen an die Spannungsversorgungseinrichtung angeschlossene Zuleitung im Hinblick auf eine Leitungsunterbrechung überprüfen zu können, kann er zur Stromeinsparung während eines vorgegebenen Zeitraumes, z. B. während der Stillstandszeit eines Kraftfahrzeuges, während der eine Überprüfung der Zuleitungen des Schalters oder Sensors nicht erforderlich ist, abgeschaltet werden.

Dies erfolgt nach einer Weiterbildung der Erfindung vorteilhaft dadurch, daß in dem den zweiten ohmschen Widerstand enthaltenden Stromzweig der durch den ersten und zweiten ohmschen Widerstand sowie durch den Schalter oder Sensor gebildeten Parallelschaltung eine Zener-Diode vorgesehen ist und daß die Spannungsversorgungseinrichtung von einer größeren auf eine im Vergleich zur Durchbruchspannung der Zener-Diode kleinere Ausgangsspannung umschaltbar ist. Beim Einsatz einer derartigen Schaltungsanordnung in einem Kraftfahrzeug wird die Spannungsversorgungseinrichtung vorzugsweise so geschaltet, daß sie während des Fahrbetriebes des Kraftfahrzeuges eine Ausgangsspannung abgibt, die größer ist als die Durchbruchsspannung der Zener-Diode, mit der Folge, daß diese in Sperrichtung leitend geschaltet ist. In diesem Zustand kann bei geöffnetem Schalter oder Sensor über den zweiten oder dritten ohmschen Widerstand ein Diagnosestrom fließen, der für die Feststellung einer Leitungsunterbrechung der stromführenden Leitung des Schalters oder Sensors benötigt wird. Zur Abschaltung des zweiten ohmschen Widerstandes während des Kraftfahrzeugstillstandes wird die Spannungsversorgungseinrichtung auf eine Ausgangsspannung umgeschaltet, die kleiner ist als die Durchbruchsspannung der Zener-Diode. Durch diese Maßnahme wird die Zener-Diode in Sperrichtung sperrend geschaltet, mit der Folge, daß durch den den zweiten ohmschen Widerstand enthaltenden Stromzweig kein Diagnosestrom mehr fließen kann. Es wird dadurch erreicht, daß die erfindungsgemäße Schaltungsanordnung während des Kraftfahrzeugstillstandes mit Ausnahme des vernachläßigbaren Leckstromes der Zener-Diode keinen Strom aufnimmt.

Bei einer zweiten, alternativen Möglichkeit zur Abschaltung des zweiten ohmschen Widerstandes ist in dem den zweiten ohmschen Widerstand enthaltenden Stromzweig der Parallelschaltung ein elektronischer Schalter vorgesehen. Beim Einsatz dieser Schaltungsanordnung im Kraftfahrzeug ist der Steuereingang des elektronischen Schalters vorzugsweise derart an den Zündstromkreis des Kraftfahrzeuges angeschlossen, daß der elektronische Schalter beim Schließen des Zündschalters leitend geschaltet und beim Öffnen des Zündschalters sperrend geschaltet wird. Es wird dadurch erreicht, daß nur bei geschlossenem Zündschalter, also in der Regel im Fahrbetrieb des Kraftfahrzeuges, wenn der Generator des Kraftfahrzeuges den Akkumulator ständig nachlädt, ein Diagnosestrom durch den lediglich für die Überprüfung der Zuleitungen des Schalters oder Sensors erforderlichen aber für die Funktion des Schalters oder Sensors nicht benötigten zweiten ohmschen Widerstand fließen kann. Dadurch, daß bei offenem Zündschalter kein Diagnosestrom durch den für die Funktion des Schalters oder Sensors nicht benötigten zweiten ohmschen Widerstand fließen kann, wird ein Entladen des Akkumulators während eines Kraftfahrzeugstillstandes vermieden.

Vorzugsweise wird als elektronischer Schalter ein Transistor verwendet.

Im folgenden werden zwei Ausführungsbeispiele der Erfindung anhand der Figuren erläutert. Es zeigen:
Fig. 1 ein erstes Ausführungsbeispiel der Erfindung und
Fig. 2 ein zweites Ausführungsbeispiel der Erfindung.

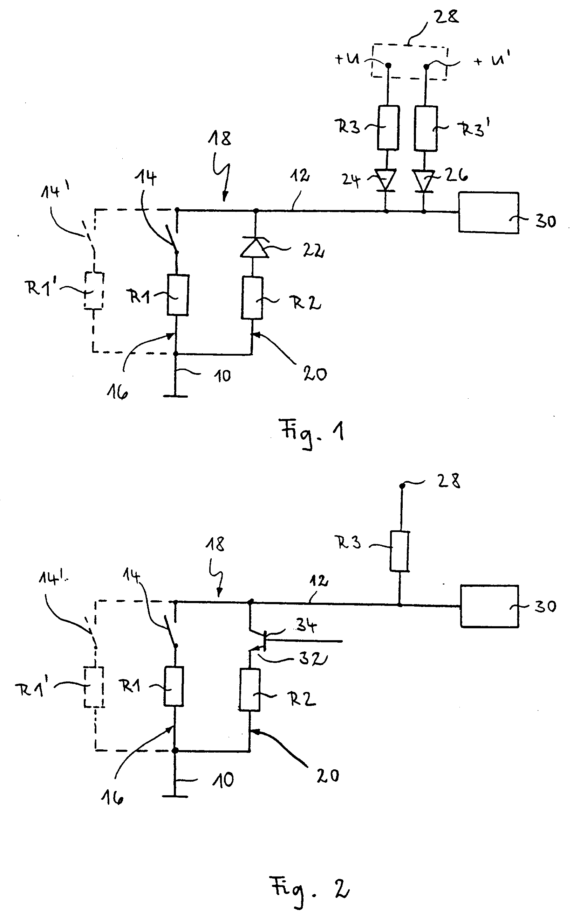

Die in Fig. 1 dargestellte Schaltungsanordnung zur Überprüfung der Zuleitungen 10 und 12 eines im Ruhezustand offenen Schalters 14 umfaßt einen mit diesem in Reihe geschalteten ersten ohmschen Widerstand R1. Der Schalter 14 und der ohmsche Widerstand R1 bilden dabei einen ersten Stromzweig 16 einer insgesamt mit 18 bezeichneten Parallelschaltung, in deren zweiten Stromzweig 20 ein zweiter ohmscher Widerstand R2 und eine Zener-Diode 22 liegen. Die zweite Zuleitung 12 des Schalters 14 und damit auch der Parallelschaltung 18 ist einerseits über eine erste Entkopplungsdiode 24 und einen dritten Widerstand R3 sowie über eine zweite Entkopplungsdiode 26 und einen ohmschen Widerstand R3′ an eine hinsichtlich ihrer Ausgangsspannung von + U auf + U′ und umgekehrt umschaltbare Spannungsversorgungseinrichtung 28 angeschlossen und andererseits mit einer Spannungsdiskriminatoreinheit 30 verbunden. Dagegen liegt die erste Zuleitung 10 des Schalters 14 und damit der Parallelschaltung 18 an Erdpotential. An die Zuleitungen 10 und 12 können neben dem Schalter 14 auch noch weitere parallel zu diesem liegende Schalter angeschlossen werden. In der Fig. 1 ist ein solcher weiterer Schalter 14′ zusammen mit einem mit diesem in Serie liegenden weiteren ersten ohmschen Widerstand R1′ gestrichelt dargestellt.

Nachdem vorstehend der schaltungstechnische Aufbau der in der Fig. 1 dargestellten Schaltungsanordnung beschrieben worden ist, wird im folgenden die Funktionsweise dieser Schaltungsanordnung erläutert.

Mit der in der Fig. 1 dargestellten Schaltungsanordnung kann überprüft werden, ob die Zuleitungen 10 und 12 des im Ruhezustand offenen Schalters 14 intakt sind. Um beim Einsatz dieser Schaltungsanordnung in einem Kraftfahrzeug auch einen Kurzschluß der Zuleitungen 10 und 12 des Schalters 14 gegen die Akkumulatorspannung des Kraftfahrzeuges feststellen zu können, ist es erforderlich, daß die Spannungsversorgungseinrichtung 28 eine Ausgangsspannung + U abgibt, die kleiner als die Akkumulatorspannung und größer als die Durchbruchspannung der Zener-Diode 22 ist. In diesem Falle kann von der Spannungsdiskriminatoreinheit 30 einerseits der jeweilige Schaltzustand des Schalters 14 sicher erkannt werden und andererseits festgestellt werden, ob bei den Zuleitungen 10 und 12 ein Kurzschluß gegen Erdpotential, ein Kurzschluß gegen die Akkumulatorspannung oder eine Leitungsunterbrechung vorliegt. Liegt beispielsweise bei der Zuleitung 12 ein Kurzschluß gegen die Akkumulatorspannung vor, so liegt am Eingang der Spannungsdiskriminatoreinheit 30 die Akkumulatorspannung an. Liegt dagegen ein Kurzschluß gegen Erdpotential vor, so liegt am Eingang der Spannungsdiskriminatoreinheit 30 das Erdpotential an. Ist die Zuleitung 12 schließlich unterbrochen, so liegt am Eingang der Spannungsdiskriminatoreinheit 30 die von der Spannungsversorgungseinrichtung 28 abgegebene Spannung + U an. Diese Fehlerzustände können von der Spannungsdiskriminatoreinheit 30 sicher erkannt werden, da vorstehend genannte Spannungswerte am Eingang der Spannungsdiskriminatoreinheit 30 nur bei einer fehlerhaften Zuleitung 12 auftreten. So stellt sich bei intakten Zuleitungen 10 und 12 bei offenem Schalter 14 am Eingang der Spannungsdiskriminatoreinheit 30 eine Spannung ein, die durch die Spannung + U der Spannungsversorgungseinrichtung 28 und durch den aus den ohmschen Widerständen R2 und R3 und der Zener-Diode gebildeten Spannungsteiler bestimmt wird. Bei intakten Zuleitungen 10 und 12 und geschlossenem Schalter 14 stellt sich am Eingang der Spannungsdiskriminatoreinheit 30 ferner eine Spannung ein, die durch die Spannung + U der Spannungsversorgungseinrichtung 28 und dem aus der Parallelschaltung 18 und dem Widerstand R3 gebildeten Spannungsteiler bestimmt wird. Es können somit von der Spannungsdiskriminatoreinheit 30 sowohl die Schaltzustände des Schalters 14 bei intakten Zuleitungen 10 und 12 als auch die verschiedenen Fehlerzustände der Zuleitungen 10 und 12 zum Schalter 14 eindeutig erkannt werden. Dabei wird der zum Schalter 14 und zum ohmschen Widerstand R1 parallel geschaltete ohmsche Widerstand R2 jedoch nur benötigt, damit die Spannungsdiskriminatoreinheit 30 eine Leitungsunterbrechung der Zuleitung 12 bei offenem Schalter 14 feststellen kann. Während für den Fall, daß der ohmsche Widerstand R2 nicht vorhanden bzw. abgeschaltet ist, bei offenem Schalter 14 am Eingang der Spannungsdiskriminatoreinheit 30 ebenso wie bei einem Bruch der Zuleitung 12 die Ausgangsspannung der Spannungsversorgungseinrichtung 28 anliegt, stellt sich bei zum offenen Schalter 14 parallel geschaltetem ohmschen Widerstand R2 am Eingang der Spannungsdiskriminatoreinheit 30 eine Spannung ein, die durch die Ausgangsspannung der Spannungsversorgungseinrichtung 28 und durch den aus den ohmschen Widerständen R2 und R3 und der Zener-Diode gebildeten Spannungsteiler bestimmt wird. Da sich diese Spannung von der der Ausgangsspannung der Spannungsversorgungseinrichtung unterscheidet, kann ein Bruch der Zuleitung 12 des Schalters 14 sicher festgestellt werden.

Die Parallelschaltung des ohmschen Widerstandes R2 zum Schalter 14 hat aber den Nachteil, daß auch bei offenem Schalter 14 ständig ein Diagnosestrom durch die ohmschen Widerstände R2 und R3 fließt, was einen relativ hohen Stromverbrauch zur Folge hat. Um diesen Stromverbrauch zu verringern, wird bei der erfindungsgemäßen Schaltungsanordnung der Widerstand R2, ohne die Funktionsfähigkeit des Schalters 14 dabei zu beeinträchtigen, während der Zeiträume abgeschaltet, während der eine Überprüfung der Zuleitungen 10 und 12 zum Schalter 14 durch die Spannungsdiskriminatoreinheit 30 nicht erforderlich ist. Beim Einsatz einer derartigen Schaltungsanordnung in einem Kraftfahrzeug wird man den Widerstand R2 vorzugsweise bei geöffnetem Zündstromkreis, also bei Stillstand des Kraftfahrzeuges abschalten, um den Akkumulator des Kraftfahrzeuges nicht unnötig zu belasten und damit auch nach einer längeren Stillstandszeit des Kraftfahrzeuges ein Starten des Kraftfahrzeugmotors zu gewährleisten. Die Abschaltung des Widerstandes R2 erfolgt bei der in der Fig. 1 dargestellten Schaltungsanordnung dadurch, daß die Spannungsversorgungseinrichtung 28 von der Ausgangsspannung + U auf die Ausgangsspannung + U′ umgeschaltet wird, die kleiner als die Durchbruchspannung der Zener-Diode 22 ist, wodurch diese sperrend geschaltet wird.

Die in der Fig. 2 dargestellte Schaltungsanordnung unterscheidet sich von der in Fig. 1 dargestellten Schaltungsanordnung lediglich durch eine andere Art der Abschaltung des ohmschen Widerstandes R2. Bei der in Fig. 2 dargestellten Schaltungsanordnung, deren mit der Schaltungsanordnung von Fig. 1 übereinstimmende Teile mit den entsprechenden Bezugszeichen der Schaltungsanordnung von Fig. 1 bezeichnet sind, ist zur Abschaltung des ohmschen Widerstandes R2 in dem diesen enthaltenden Stromzweig 20 der Parallelschaltung 18 ein Transistor 32 als elektronischer Schalter vorgesehen, durch den der Stromzweig 20 unterbrochen werden kann. Beim Einsatz dieser Schaltungsanordnung in einem Kraftfahrzeug, ist die Steuerelektrode 34 des Transistors 32 vorzugsweise an den Zündstromkreis des Kraftfahrzeuges angeschlossen. Auf diese Weise wird erreicht, daß nur bei geschlossenem Zündstromkreis ein Diagnosestrom durch den Stromkreis 20 der Parallelschaltung 18 fließt, während bei offenem Zündstromkreis der Stromzweig 20 der Parallelschaltung 18 durch den dann sperrend geschalteten Transistor 32 unterbrochen wird.

Aufgrund der Abschaltbarkeit des nur zu Diagnosezwecken benötigten ohmschen Widerstandes R2 kann die erfindungsgemäße Schaltungsanordnung im Kraftfahrzeugbau auch zur Überwachung der Zuleitungen von Schaltern oder Sensoren verwendet werden, die nicht erst durch das Schließen des Zündschalters an die Spannungsversorgungseinrichtung gelegt werden, sondern die ständig an der Spannungsversorgungseinrichtung angeschlossen sind, um auch bei offenem Zündschalter funktionsfähig zu sein.

## Patentansprüche

1. Schaltungsanordnung zur Überprüfung der Zuleitungen (10, 12) eines im Ruhezustand offenen Schalters oder Sensors (14) mit einem mit diesem in Reihe geschalteten ersten ohmschen Widerstand (R1), der zusammen mit dem Schalter oder Sensor (14) und einem parallel zu beiden liegenden zweiten ohmschen Widerstand (R2) eine Parallelschaltung (18) bildet, deren erste Zuleitung (10) an Erdpotential und deren zweite Zuleitung (12) einerseits über einen dritten ohmschen Widerstand (R3) an eine Spannungsversorgungseinrichtung (28) angeschlossen und andererseits mit einer Spannungsdiskriminatoreinheit (30) verbunden ist,
dadurch gekennzeichnet, daß der zweite ohmsche Widerstand (R2) zur Stromeinsparung während eines vorgegebenen Zeitraumes, während der eine Überprüfung der Zuleitungen (10, 12) des Schalters oder Sensors (14) nicht erforderlich ist, abgeschaltet ist.

2. Schaltungsanordnung nach Anspruch 1,
dadurch gekennzeichnet, daß in dem den zweiten ohmschen Widerstand (R2) enthaltenen Stromzweig (20) der Parallelschaltung (18) eine Zener-Diode (22) vorgesehen ist und daß die Spannungsversorgungseinrichtung (28) zur Abschaltung des zweiten ohmschen Widerstandes (R2) von einer größeren auf eine im Vergleich zur Durchbruchspannung der Zener-Diode kleinere Ausgangsspannung umschaltbar ist.

3. Schaltungsanordnung nach Anspruch 1,
dadurch gekennzeichnet, daß in dem den zweiten ohmschen Widerstand (R2) enthaltenen Stromzweig (20) der Parallelschaltung (18) ein elektronischer Schalter (32) vorgesehen ist.

4. Schaltungsanordnung nach Anspruch 3,
dadurch gekennzeichnet, daß der elektronische Schalter (32) durch einen Transistor gebildet ist.

## Claims

1. A circuit arrangement for checking the leads (10, 12) to a switch or sensor (14) which is open in the inoperative position, a first ohmic resistor (R1) being connected in series with the switch or sensor (14) and co-operating therewith, and with a second ohmic resistor (R2) parallel to both, to form a parallel circuit (18) having a first lead (10) at earth potential and a second lead (12) connected via a third ohmic resistor (R3) to a voltage supply device (28) and also connected to a voltage discriminator unit (30), characterised in that, in order to save electricity, the second ohmic resistor (R2) is switched off for a preset time during which it is unnecessary to check the leads (10, 12) of the switch or sensor (14).

2. A circuit arrangement according to claim 1, characterised in that a Zener diode (22) is provided in the branch (20) of the parallel circuit (18) containing the second ohmic resistor (R2), and, in order to switch off the second ohmic resistor (R2), the voltage supply device (28) can be switched over from a relatively large starting voltage to a voltage which is smaller than the breakdown voltage of the Zener diode.

3. A circuit arrangement according to claim 1, characterised in that an electronic switch (32) is provided in the branch (20) of the parallel circuit (18) containing the second ohmic resistor (R2).

4. A circuit arrangement according to claim 3, characterised in that the electronic switch (32) is a transistor.

## Revendications

1. Circuit de contrôle des fils (10, 12) d'un interrupteur ou d'un détecteur (14) ouvert en position de repos avec une première résistance (R1) ohmique montée en série avec celui-ci, qui forme un circuit (18) parallèle conjointement avec l'interrupteur ou détecteur (14) et une deuxième résistance ohmique (R2) montée en parallèle, dont le premier fil (10) est raccordé au potentiel de la terre et dont le second fil (12) est raccordé d'une part par une troisième résistance ohmique (R3) à un dispositif d'alimentation en tension (28) et d'autre part à un discriminateur de tension (30), circuit de contrôle caractérisé en ce que la deuxième résistance ohmique (R2) est débranchée pour économiser le courant pendant un intervalle de temps prédéfini, pendant lequel il n'est pas nécessaire d'effectuer un contrôle des fils (10, 12) de l'interrupteur ou du détecteur (14).

2. Circuit de contrôle selon la revendication 1, caractérisé en ce que dans la voie d'enroulement (20) du circuit en parallèle (18) contenant la deuxième résistance ohmique (R2), il est prévu une diode Zener (22) et en ce que le dispositif d'alimentation en tension (28) peut être commuté, pour débrancher la deuxième résistance ohmique (R2), d'une tension de sortie plus grande sur une tension de sortie plus petite par comparaison avec la tension de coupure de la diode Zener.

3. Circuit de contrôle selon la revendication 1, caractérisé en ce que dans la voie (20) contenant la deuxième résistance ohmique (R2) du circuit en parallèle (18), il est prévu un interrupteur électronique (32).

4. Circuit de contrôle selon la revendication 3, caractérisé en ce que l'interrupteur électronique (32) est constitué par un transistor.
